# EUROPEAN PATENT APPLICATION

(11) **EP 3 086 202 A1**
(43) Date of publication of application: **26.10.2016**
(21) Application number: 15305605.6
(22) Date of filing: 22.04.2015
(51) Int. Cl.: G06F 1/20, G02B 6/42, H05K 7/20, H01L 23/373, H01L 23/427

(54) **THERMAL INTERFACE**

(71) Applicant: ALCATEL LUCENT, 92100 Boulogne-Billancourt (FR)
(72) Inventor: Donnelly, Brian G, Dublin (IE); Burns, Ollie, Dublin (IE); McGarry, Liam, Dublin (IE); Farrelly, Rayhaan, Dublin (IE)
(74) Representative: Berthier, Karine

(57) **Abstract**

A thermal interface for providing a thermal link between a detachable heat source and heat sink is disclosed. The thermal interface comprises: a thermal transfer surface for transferring heat between said heat source and said heat sink; and a thermally conductive heat fusible material 30 having a melting temperature of between 15 and 110°C, the heat fusible material being configured to flow over at least a portion of the thermal transfer surface when in a liquid state and rigidly adhering to the thermal interface surface when in a solid state.

## Description

### FIELD OF THE INVENTION

The field of the invention relates to thermal interfaces.

### BACKGROUND

In the field of data processing and wireless communication the amount of data traffic has increased hugely in a short space of time. The devices and circuits used in these applications are often heat sensitive and thus, it is important that any temperature rise due to this increase in data traffic is controlled. Pluggable optics at the faceplate, for example, are generating more and more heat due to this increase in data traffic. With the current trend in electronics leaning towards smaller products, higher density and weight restrictions, pluggable optics in particular are getting smaller with an increase in thermal density. Thus, the provision of thermal interfaces to allow heat to be drawn away from such devices to heat sinks where the heat can be dissipated is becoming increasingly important.

Many such devices such as optical plug connecting devices, for example XFP's, also need to be hot swappable and as such need a thermal interface that can perform a high number of make/breaks without affecting the performance of the connector. It is also advantageous if such connectors do not require the re-application of thermal pastes or the use of special tooling.

There is also a requirement for this type of detachable thermal connector in other electronic products such as in IP Routing and Technology. As power demands and data traffic demands continue to grow, it is becoming advantageous to remove heat from board mounted components to the chassis itself where there is more space for cooling or simply more surface area. Input/output modules are now becoming the bottleneck for transmission of data due to these high heat loads and demands put on them and as such they are putting a strain on the reliability and quality of network services.

Furthermore, in order to maintain the pluggable nature of such boards, a thermal interface that allows the modules to have a low insertion force in addition to the characteristics mentioned above is desirable.

It would be desirable to provide a thermal interface between a detachable heat source and heat sink that addresses at least some of these issues.

### SUMMARY

A first aspect of the present invention provides a thermal interface for providing a thermal link between a heat source and heat sink, said heat source and heat sink being detachable from each other, said thermal interface comprising: a thermal transfer surface for transferring heat between said heat source and said heat sink; and a thermally conductive heat fusible material having a melting temperature of between 15 and 110°C, said heat fusible material being configured to flow over at least a portion of said thermal transfer surface when in a liquid state and to rigidly adhere to said thermal interface surface when in a solid state.

The inventors of the present invention recognised that where a thermal interface provides a link between a heat source and a heat sink that are detachable from each other, providing this link with high thermal conductivity while allowing the connection to be made or broken at will is problematic. Where two surfaces abutt there will typically be some gaps between the surfaces due to irregularities of the contacting surfaces. Such gaps are filled with air and air is a very bad thermal conductor and as such these air gaps lead to a decrease in thermal conductivity. The use of thermal greases to address this has disadvantages where the connection is detachable as reconnections lead to the grease becoming dislodged and also over time drying out.

The use of a heat fusible material which is solid at temperatures above 15°C and which rigidly adheres to the thermal interface when solid, allows the devices to be connected and disconnected at the heat transfer surface with the material held firmly in place on the thermal interface provided the temperature is below this temperature. When the thermal transfer surface reaches a certain temperature in use, the heat fusible material will melt and the liquid material will coat at least a portion of the heat transfer surface providing a good thermal connection between the heat source and heat sink. In this way heat can be transferred from a heat source to a heat sink via a thermal path whose thermal conductivity increases as the heat source heats up and the heat fusible material melts.

In this regard the heat sink may be used to keep electronic components from overheating. Many electronic components fail at higher temperatures, power amplifiers for example should be kept below 120°C. Thus, a heat fusible material that is solid at lower temperatures allowing it to adhere to the heat transfer surface when not heated and therefore during connection and disconnection, but which melts at a temperature that is below the temperature of failure of the components that the heat sink is protecting in this case below 110°C and in so doing improves the thermal conductivity of the path between the heat source and heat sink allowing heat to flow and halting or at least slowing down the rise in temperature at the heat source is advantageous. In this way the temperature critical components at the heat source are protected and yet provided the devices are at room temperature or at a temperature below the phase transition of the heat fusible material, then they can be can be freely connected and disconnected at this surface without damaging or losing the thermal interface material.

In some embodiments a temperature range of between 15°C and 80°C is preferred. Where the components being protected are electronic components such as CPUs then these components should be protected from temperatures of more than 85°C and as such a fusible material that melts at a temperature of 80°C or less will be appropriate. In other embodiments where the components being protected are optical components where a high temperature causes a shift in laser wavelength then then they should be kept below 70°C and as such a fusible material that melts at a temperature of 65°C or less is desirable. In some embodiments a material that becomes a solid below a temperature of 30°C may be preferred as connection and disconnection can then be performed at most ambient temperatures. In this regard many connections and disconnections may be performed at data centres where the ambient temperature is held at about 20°C. In some embodiments a temperature range of between 45 and 60°C may be particularly advantageous as in this case the material is solid even in a very warm room and yet melts in good time before a temperature that might damage the electronics is reached. It should be noted that although a heat fusible material that melts at a higher temperature may provide protection for some electronic components, those that melt at lower temperatures also provide protection and will help keep the temperature of the components lower, which may allow their performance to improve, the performance of many electronic components falling with increasing temperature.

In some embodiments, said heat fusible material expands on melting and contracts on solidifying.

A material that expands on melting and contracts on solidifying is particularly useful as a thermal interface material as it provides a good thermal contact between opposing surfaces of the connected devices when melted but retracts on solidifying leaving a gap between the surfaces allowing simple disconnection and reconnection. In some embodiments the material may expand to have a volume that is more than 10% greater in the liquid phase than it has in the solid phase, preferably more than 20% greater in the liquid phase than in the solid phase.

In some embodiments, said heat fusible material comprises bismuth.

It has been found that including bismuth in the material will provide the material with the desired expansion properties.

In some embodiments, said thermal transfer surface comprises a plurality of depressions, said plurality of depressions containing said heat fusible material when in solid form.

A convenient way of containing the heat fusible material and allowing the heat source and heat sink to be disconnected and connected at temperatures below the phase transition temperature of the liquid heat fusible material is to provide depressions on the thermal transfer surface into which the solidified material will retract, leaving the thermal transfer surface substantially free from heat fusible material. On melting of the material it will expand out of the depressions and move into any gap between the surfaces improving thermal conduction between them and pushing out any air whose thermal conductive properties are very poor.

Although the heat fusible material can be any material with a melting point in the desired range and with a good thermal conductivity, in some embodiments a metal alloy is used, while in other embodiment the material may be a plastic with a high thermal conductivity. In this regard good thermal conductivity may depend on the application but in some cases may be 20 W/m/K while in others it may be viewed as a thermal conductivity similar to aluminium that is 100 W/m/K or above.

In some embodiments, said alloy comprises an alloy of bismuth, tin and indium.

One alloy which has a melting point that is particularly applicable to protecting electronic components being around 55-60°C and which expands when melting is an alloy of bismuth, tin and indium sometimes called "field's" metal. Furthermore, this metal does not contain heavy metals whose disposal is difficult such as cadmium and lead.

In some embodiments, said thermal transfer surface is treated to increase a wettability of said surface to said liquid heat fusible material.

As noted previously, when disconnecting the heat source and heat sink, the heat fusible material adheres to the thermal interface when in a solid form and is therefore removed with it. In order to improve this adherence and also to reduce the possibility of the liquid material flowing away from the thermal transfer material and leaking into other components when molten, it is advantageous if the thermal transfer surface is treated in some way to increase the wettability of this surface to the liquid heat fusible material. In this way when in liquid form the heat fusible material will preferentially stick to the heat transfer surface of the connector.

In this regard, the treatment may take a number of different forms. For example, where the surface is copper it has been found that treating it with hydrochloric acid to remove any oxides forms a surface which is very wettable to field's metal for example and thus, such a treatment can be advantageous. Furthermore, where the opposing surface is aluminium which is a common material in electronics, then this material when untreated has a very low wettability to material such as field's metal and as such can be viewed as phobic to these materials such that the heat fusible material when liquid will preferentially attach to the thermal transfer surface of the detachable component and not to the corresponding surface. In this regard, where the detachable component is for example a heat sink, then copper is a useful material and where the heat source is an XFP connector for example, then it may well be formed of aluminium and as such, the use of an alloy like field's metal as the heat fusible material, will provide a thermal interface where the material in liquid form preferentially sticks to the surface of the detachable heat sink.

In some embodiments, said thermal transfer surface is treated by coating said surface with a substance that increases a wettability of said heat transfer surface to said liquid heat fusible material.

One way of treating the surface to increase its wettability may be to coat the surface with another substance. For example, where the thermal transfer surface is aluminium, then as noted previously, this is not wettable by many alloys. However, coating the surface with for example nickel or tin, will increase its wettability to these alloys and make it a surface that the heat fusible material will stick to when wet.

In some embodiments, the thermal transfer surface further comprises a retaining projection projecting from said thermal transfer surface and operable to retain said heat fusible material adjacent to said thermal transfer surface when said connector is in a connected state and said heat fusible material has melted.

One potential problem associated with a heat fusible material that becomes liquid at a certain temperature is that it may be hard to retain on the thermal transfer surface and where it is electrically conductive which is often the case with good thermal conductors, then its leaking into electronic components can be disastrous. Therefore, it is important that it is retained on the thermal transfer surface. As noted previously, treating the surface to increase the wettability to the material when liquid is one way of helping to retain the material adjacent to the surface. One further way in which this can be achieved is by the use of one or more retaining projections which project from the thermal transfer surface and thus, on attachment to the other component, contact the opposing surface forming a retaining barrier for the liquid material. In this regard, it should be noted that the arrangement will have a certain orientation and the retaining projection can be arranged such that it is at the lower side when the devices are connected such that any material that may flow down due to gravity, is retained in place by this projection. Alternatively, in some embodiments, it may take the form of a ring enclosing the whole of the thermal transfer surface.

A second aspect of the present invention provides a detachable connector for connecting a heat source to a heat sink, said detachable connector comprising said thermal interface according to a first aspect of the present invention.

It should be noted that the detachable connector may be a part of one of the heat sink or heat source and have a form or means for attaching in a removable manner to the other component. The heat source may be a number of things but in general it is some component that generates heat by processing or transferring data and requires this heat to be removed. The detachable connector provides a thermal path between the heat source and heat sink when it is connected and this allows heat to pass from the heat source to the heat sink in an efficient manner.

When connected the heat transferring surface of the detachable connector abuts a corresponding surface on the other component forming a thermal transfer path for heat to flow from the warmer to the cooler surface. The heat fusible material will melt in response to a sufficient increase in temperature and as it is present between the two surfaces it will improve the thermal conductivity between these surfaces.

As noted previously by providing a thermal interface material that when it melts moves to fill a gap between surfaces and in this way increases the thermal conductivity of a thermal path between them and when it solidifies retracts from one of the surfaces and adheres to the other allows a connector to be formed with high thermal conductivity properties when warm and with easy removal properties at lower temperatures. Thus, a connector is provided with excellent thermal properties that can be connected and disconnected with a low force and does not require maintenance to retain these thermal properties.

In some embodiments, the detachable connector further comprises a spring loaded connecting member for biasing said thermal transfer surface towards a corresponding surface when said detachable connector is connected.

It may be advantageous if the detachable connector is biased towards the component it is attached to when it is connected. This can improve the thermal contact between the thermal transfer surface and the corresponding surface of the attached component. In particular, when the heat fusible material melts, it can fill the gap pushing against spring loaded contact and providing a good thermal link.

In some embodiments, said detachable connector comprises a recess for enclosing a protruding portion of a device to which it is connected, said recess being at least partially coated with said heat fusible material and comprising a retaining ring at an outer edge of said recess for retaining said heat fusible material when liquid.

Although the detachable connector can take a number of forms, in some cases it may be of a socket form adapted to attach to a plug-like connector on the corresponding component. In such a case, the recess forming the socket may have a retaining ring around the edge such the heat fusible material is retained within the socket recess when liquid. A plug and socket connector is a convenient form for connecting two devices and has a fairly large connecting surface running off the socket and corresponding plug making thermal transfer efficient. Furthermore, it is a convenient shape in which to retain any liquid material with the use of a retaining ring around the outer edge of the socket.

Although the detachable connector may simply be a connector for connecting a heat sink and a heat source, it may in some embodiments be the heat source, or said detachable connector may comprise the heat sink, the thermal transfer surface being in thermal contact with the heat sink.

It may be advantageous if the heat sink itself has a detachable connector on it so that the detachable connector comprises the heat sink itself and in effect you have a heat sink with a thermal transfer surface having a heat fusible material that is detachably connected to the heat source that it is aiming to cool.

A third aspect of the present invention provides, a heat sink comprising a thermal interface according to a first aspect of the present invention and a heat sink body said heat sink body being in thermal contact with said thermal transfer surface.

A fourth aspect of the present invention provides a thermal transfer assembly comprising a heat sink and a heat source, said heat sink being connected to said heat source by said detachable connector according to a second aspect of the present invention, wherein said heat sink and said heat source are connected such that said thermal transfer surface abuts a corresponding surface of one of said heat source and said heat sink, said thermal transfer and corresponding surfaces being arranged such that said heat fusible material when melted at least partially fills a gap between said thermal transfer surface and said corresponding surface providing an improved thermally conductive path between said heat sink and said heat source.

In some embodiments, said thermal transfer surface is more wettable to said heat fusible material than said corresponding surface.

As noted previously, it is advantageous if the thermal transfer surface is wettable to the heat fusible material allowing it to preferentially adhere to it when liquid. It is also advantageous if the opposing surface to the heat transfer surface when the connector is connected is less wettable and in this way, the heat fusible material remains on the thermal transfer surface and when cooled and the detachable connector is disconnected, this material is not lost but will have adhered in solid form to the connector and be removed with it.

Although this heat fusible material may have many forms, in some embodiments it is a metal alloy and in some cases field's metal.

A fifth aspect to the present invention provides a method of adapting a connector for connecting a heat source and a heat sink comprising providing a heat fusible material having a melting temperature of between 15 and 110°C on at least a portion of a thermal transfer surface of said connector such that when solid said heat fusible material rigidly adheres to said at least a portion of said thermal transfer surface.

In addition to providing thermally efficient detachable connectors for connecting heat sources and heat sinks, an aspect of the invention may also be used to adapt existing connections to improve their thermal conductivity. In this regard, by applying the heat fusible material to one of the heat transfer surfaces between the heat sink and heat source, an improvement in thermal conductivity between the devices can be achieved.

In some embodiments, the method comprises a further step of prior to providing said heat fusible material, treating a surface of said thermal transfer surface to increase its wettability to said heat fusible material.

When adapting an existing detachable connector, it may be advantageous to treat the surface prior to applying the heat fusible material in such a way that the heat fusible material will adhere preferentially to this surface when liquid and this will decrease the chance of this material being lost when liquid.

Although the heat fusible material can take a number of forms, it may be advantageous to use a metal alloy when adapting an existing connector. A metal alloy may have the required melting point and is also generally a good thermal conductor. Furthermore, aluminium for example is non wetting for many fusible metal alloys, so that where this is the surface connected to, then the heat fusible material will stick to the connector and be repelled by the device that it is connected to allowing it to be retained by the thermal transfer surface of the connecting device and reducing any potential losses.

In summary embodiments provide a thermal interface that has the benefits of low thermal resistance, low insertion force, allowing multiple insertion and removal cycles of the connector with a dry contact when cold through the use of a low melt material and novel geometry.

Good thermal conductivity may be viewed as that of aluminium and above so greater than about 100W/m/K, while very good is copper at 400W/m/K, anything above 20W/m/K could be viewed as thermally conductive

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figures 1 and 2 illustrate a conventional cooling mechanism for an XFP plug using a heat sink before and after insertion of an XFP plug, respectively;
Figure 3 shows a standard aluminium XFP heat sink that has been coated with nickel and a copper heat sink that has been treated with hydrochloric acid to increase the wettability of the surface to the heat fusible alloy according to embodiments;
Figures 4A to 4C show surface geometries on aluminium and copper heat sinks according to embodiments;
Figure 5 shows the difference in thermal resistance for heat transfer to a heat sink with a thermal interface with and without a fusible alloy;
Figures 6A and 6B show a thermal connector according to an embodiment;
Figure 7A and 7B shows the heat transfer when the thermal connectors of Figures 6A and 6B are connected; and
Figures 8A and 8B schematically show a heat sink and heat source with the fusible alloy in solid and liquid form.

### DESCRIPTION OF THE EMBODIMENTS

Before discussing the embodiments in any more detail, first an overview will be provided.

A thermal interface providing a thermal transfer surface between a detachable heat source and heat sink is provided where the thermal interface has several key properties, it can be connected and disconnected numerous times, allows a low insertion force and has low thermal resistance. In order to meet these requirements, in some embodiments a low temperature melting alloy is used as part of a thermal interface.

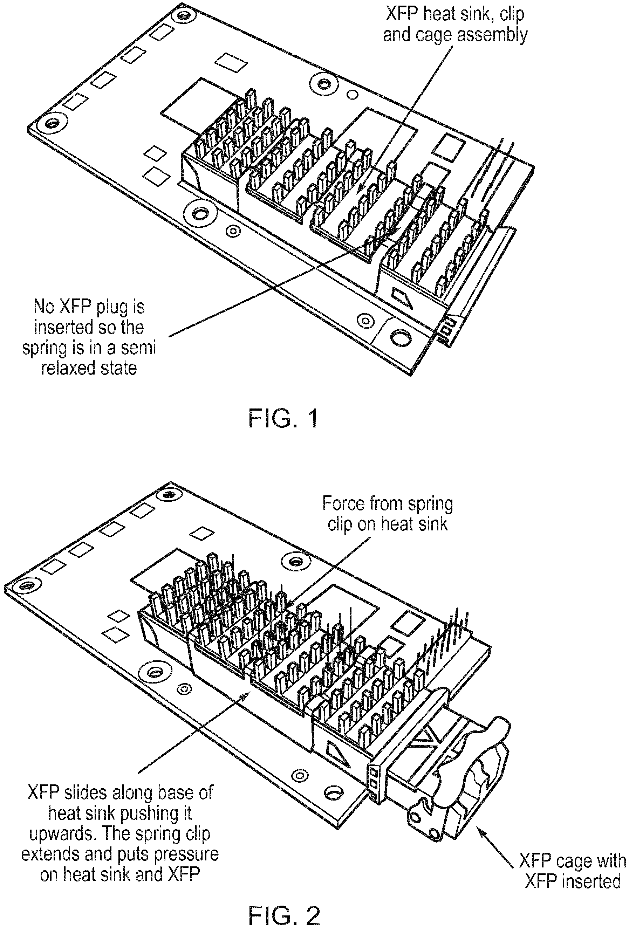

There are many thermal detachable connectors that use a 'dry' i.e. no Thermal Interface Material (TIM) contact such as those currently used in optical plugs (XFPs, CFPs etc). These types of connector simply use a small amount of pressure provided by a spring in order to force a heat sink against the heat source. This is a very ineffective way of transferring heat as the low exertion pressure and lack of Thermal Interface Material (TIM) result in a substantial amount of air in the interface (air has a very high thermal resistance), which can have a thermal resistance of up to 50% higher than when the liquid metal TIM according to embodiments is used. Figure 1 shows a conventional cooling solution, prior to an optical module (e.g. XFP) being inserted and Figure 2 shows it with an optical module slid into position. This provides a 'dry' thermal contact between plug and heat sink. Force exerted by the spring clip keeps the heat sink against the optical module.

Embodiments use a low melt temperature material with a high thermal conductivity such as an alloy (fusible alloy) to act as a thermal interface material. This material adheres to the thermal interface when solid and coats the transfer surface when liquid providing an improved thermal link. This approach will be presented in two contexts. One is aimed at optical pluggable modules and the other is aimed at creating a thermal connection between a board and chassis or device and mount. This requires a unique mechanical design in order to enable the use of the liquid metal TIM in the telecommunications industry. In principal, these are thermally the same.

A low melt temperature alloy is one whose phase changes from solid to liquid at an extremely low temperature for metals. Such metals are generally called fusible alloys when their melt temperature is lower than 150 degrees C. There are numerous fusible alloys with varying melt temperatures. For the purposes of this device a material that melts above a connection temperature which may be room temperature but below a temperature at which electronic components may fail is required. A preferred alloy is "field's metal" which is an alloy of bismuth, tin and indium. This has some important characteristics; namely it is lead and cadmium free and melts at approximately 60 degrees C. This makes it very suitable for the electronics industry and for the applications discussed above.

Other products such as metro cells can also benefit from such a connector. These types of products are mounted to a bracket that is mounted to a wall, pylon or other solid foundation. A large portion of the heat generated by these products could be transferred to the mounting bracket and dissipated to the air through the implementation of a thermal interface with the properties mentioned above.

Embodiments replace the current heat sink shown in Figures 1 and 2 with one that has its lower surface coated in fusible alloy (in its solid state). The surface geometry may be modified in order to stop the metal in its liquid state from leaking out. This allows this solution to be easily integrated into both existing and future products. In order for the fusible alloy to sufficiently wet the surface of the heat sink, it may need to be coated with a second metal or treated in some way this will be detailed later.

When you wish to break the connection in either case, the device is allowed to cool to below the melting point of the material. As it cools down past the phase transition temperature the metal solidifies. The plug will continue to cool and as such shrink due to its thermal expansion properties. This will break the bond between plug and socket, leaving the solidified fusible metal within the plug ready for reinsertion. Due to the physical properties of the fusible alloy material, we can dictate which parts of the connector or heat sink that the metal easily wets to by using surface treatments such as coatings on the metal.

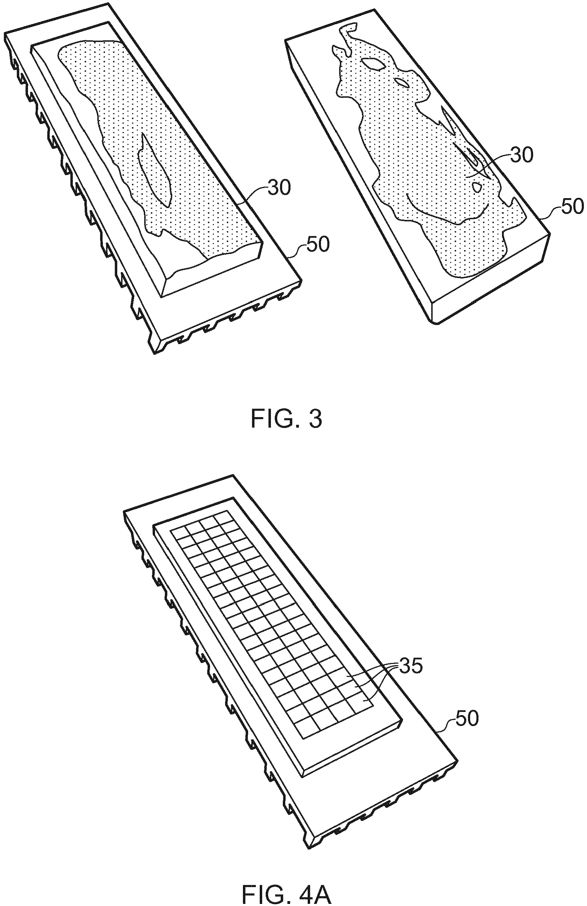

Figure 3 shows an XFP heat sink 50 that has been coated with liquid metal 30. Two heat sinks are shown, one made from aluminium and one from copper. Tests were performed on the wettability of these materials and it was found that the fusible alloy easily wets the copper surface after treatment with hydrochloric acid. Similarly, coating the aluminium heat sink in a micro layer of nickel allows wetting. This is desirable as it impedes the fusible alloy from leaking out of the space between the heat sink and XFP when in its liquid state. Since the fusible alloy will not easily wet the surface of raw aluminium which is the material of the XFP, it will preferentially just stick to the heat sink. This means that when the fusible alloy 30 solidifies, it does so only on the heat sink 50 surface. This results in all of the fusible alloy remaining on the heat sink when the XFP is removed.

The left hand side of Figure 3 shows a standard aluminium XFP heat sink 50 that has been coated with nickel in order to allow the fusible alloy 30 to wet the surface. As can be seen from the image the fusible alloy 30 forms a thin layer of now solidified metal on the surface. On the right hand side the copper heat sink 50 has been treated with hydrochloric acid to remove the thin oxide layer on the surface. After this layer has been removed, the fusible alloy 30 easily wets the surface. Once there, the layer of fusible alloy 30 protects the heat sink surface 50 from re-oxidising. This increases the lifetime of the heat sink 50 in the field. The addition of a thin layer of tin to the aluminium surface should also yield the desired effects.

In addition to surface treatments (e.g. metal coatings), machining surface features into the heat sink base can be done. These surface features will not only act as reservoirs for the fusible alloy TIM, they will allow for an increase in surface area that is in contact with the optical module. The specific geometry of these reservoirs will allow for the high surface tension of this liquid metal to be exploited and retain the liquid metal in the reservoirs as the orientation of the optical modules is in the vertical plane.

Figures 4A to C illustrate some of the possible surface geometries. When the metal is in its solidified state it is less dense than when in its liquid state. We aim to exploit this by using surface geometries. These will be such that when the fusible alloy solidifies, it retreats into the surface geometries. When the component heats up, transforming the fusible alloy into a liquid state, the alloy expands. As it expands it moves out of the surface geometries and into the small space between heat sink and XFP, thus displacing the air and improving heat transfer.

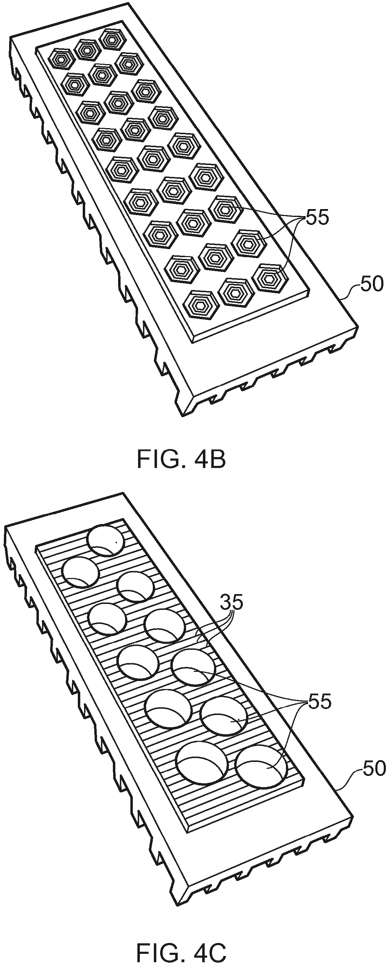

Figures 4A, 4B and 4C show some example surface geometries on the heat sink 50. Figure 4A shows the aluminium heat sink 50 with square channels 35 machined in the base, Figure 4B shows a heat sink 50 that is copper and has hexagonal cavities 55while the heat sink50 in Figure 4C has circular cavities 55 and small square channels 35. All of these geometries are designed to keep the fusible alloy retained within the heat sink. Figure 4C exploits the fact that the fusible alloy expands when liquefied. As it expands the liquefied metal travels out through the channels into the gap between the surfaces displacing any air and ensuring a lower thermal resistance between XFP and heat sink.

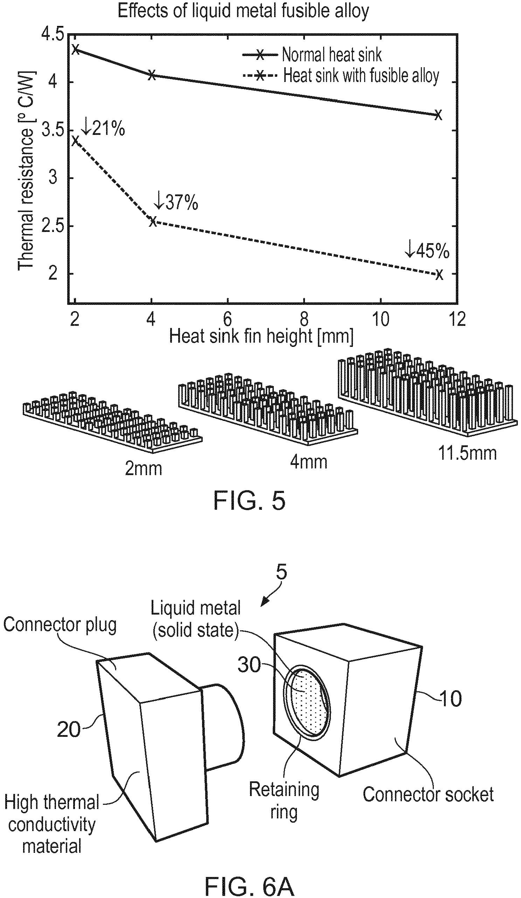

Figure 5 shows a non-limitng example of experimental results of the addition of a fusible alloy TIM between heat source and heat sink for a XFP module. As can be seen in the graph, the total thermal resistance for all heat sink heights is reduced substantially in all three cases. The x-axis shows heat sink fin height (as represented by three examples in the figure) and in all cases the fusible alloy TIM reduces the thermal resistance substantially. After letting the module cool, the plug can easily be removed.

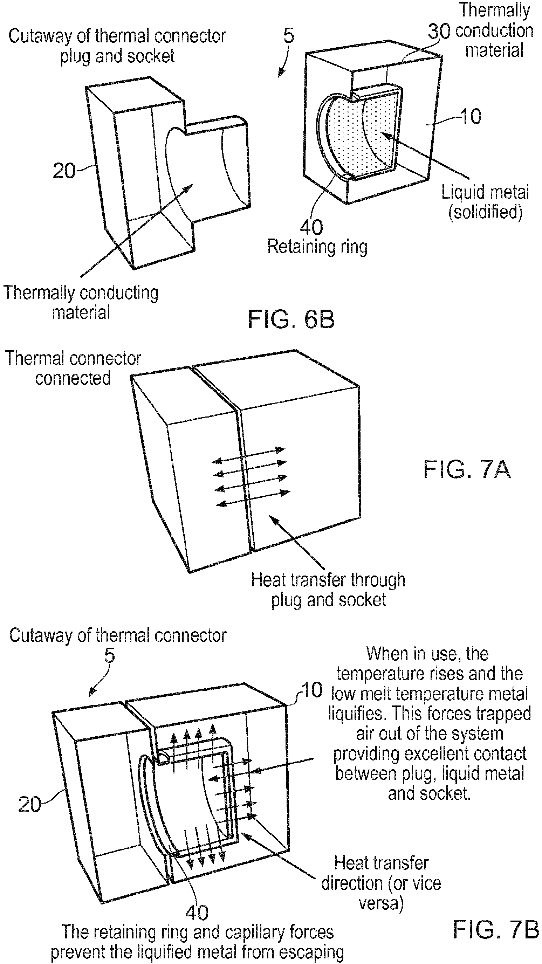

Figures 6A and 6B show an embodiment of the fusible alloy thermal connector in a generic form in its disconnected state, Figure 6A shows a normal view while Figure 6B shows a cutaway view.

The chassis based device as represented in figures 6A and 6B comprises four main parts; the plug or male part 20, the socket or female part 10, retaining ring 40 and fusible alloy 30. The plug 20 has a protrusion that inserts into the socket 10. The socket 10 contains the fusible alloy 30 in its solid state in a small space around the plug when inserted and the retaining ring 40 stops the fusible alloy from escaping. As the temperature increases past the phase transition temperature, the metal melts and makes an excellent thermal contact between the plug and socket. Heat is then transferred effectively between plug and socket or vice versa. The metal will only exist in a very small gap between the plug and the socket, which will be retained by the retaining ring on the socket. The surface may be treated with a coating that allows the fusible alloy to effectively wet the surface; this will further prevent the liquefied fusible alloy escaping.

As described above in Figure 6, the thermal connector 5 has male 20 and female 10 halves that connect to each other in order to provide an excellent thermal interface. The male 20 and female 10 parts are made from a high thermal conductivity material such as copper or aluminium. The heat source connects to one half of the connector and the heat sink to the other; i.e. it is bi-directional. As the cutaway image shows, the internal surface of the female half 10 is coated in the solidified low melt metal 30. This is due to the fact that the connector has cooled.

In this embodiment heat is transferred from the male to female part, although the heat sink and heat source could in some embodiments be the other way round. The increase in temperature causes the metal to liquefy, creating a low thermal resistance interface. The image shows the plug and socket as hollow, this is only for illustrative purposes, the plug and socket could be solid.

Figures 7A and 7B show the thermal connector 5 in its engaged state. As the temperature increases the low melt metal 30 liquefies, by using Bismuth in the content of the liquid metal which makes the liquid metal expand as it changes phase, the thermal connector forces trapped air out of the system, thus providing excellent contact between the components of the thermal connector (plug, liquid metal and socket). The retaining ring 40 acts as a seal in order to store the liquid metal 30 in the reservoir; as such it prevents the metal from escaping from within the cavity. The fusible alloy provides a low thermal resistance interface for heat to be effectively transferred.

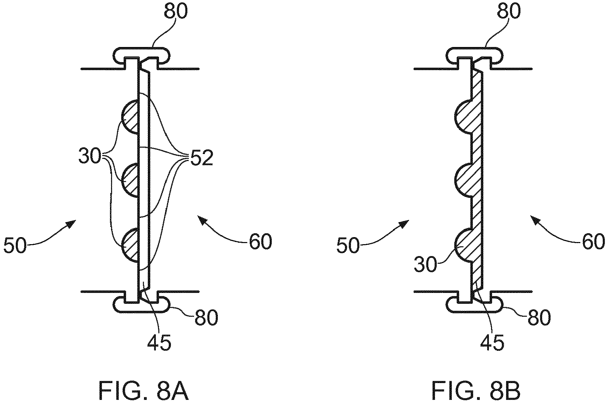

Figures 8A and 8B schematically show a heat sink 50 according to an embodiment connected to a heat source 60. Figure 8A shows the arrangement at a low temperature of less than 15°C at which temperature the thermally conductive fusible material 30 is solid and is held within recesses on the surface of the heat sink 50. Owing to the uneven surface of the heat connector 60 there is an air gap 45 between the two connecting surfaces leading to poor thermal conductivity between them despite the surfaces being biased towards each other by springs 80.

Figure 8B shows the same arrangement at a higher temperature wherein the heat fusible material 30 has melted and has expanded to coat the heat transfer surface 52 and to fill the gap 45 between the two opposing surfaces of the heat sink and heat source providing improved thermal conductivity between the heat source 60 and heat sink 50.

The unique benefits of embodiments are improved heat transfer rates. For optical modules, a thermal interface material can be used in the micro air gap between module and heat sink. The thermal interface has the unique benefit of having excellent heat transfer characteristics and does not need to be reapplied upon removal of the optical module. For chassis based products the thermal bottleneck to conducting heat away from the boards has been some form of thermal connector. With embodiments the thermal resistance should be low enough to allow heat to be removed from the board to some form of 'thermal backplane', making use of the chassis as a cooling region.

In this way embodiments provide a thermal connection solution to optical modules and chassis blades which both need to be hot swappable without the need to re-apply thermal greases or the use of special tooling.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Unless explicitly stated otherwise, each numerical value and range should be interpreted as being approximate as if the word "about" or "approximately" preceded the value or range.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A thermal interface for providing a thermal link between a heat source and a heat sink, said heat source and heat sink being detachable from each other, said thermal interface comprising:
a thermal transfer surface for transferring heat between said heat source and said heat sink; and
a thermally conductive heat fusible material having a melting temperature of between 15 and 110°C, said heat fusible material being configured to flow over at least a portion of said thermal transfer surface when in a liquid state and to rigidly adhere to said thermal interface surface when in a solid state.

2. A thermal interface according to claim 1, wherein said heat fusible material is expandable on melting and contractible on solidifying.

3. A thermal interface according to claim 2, wherein said thermal transfer surface comprises a plurality of depressions, said plurality of depressions containing said heat fusible material when in solid form.

4. A thermal interface according to any preceding claim, wherein said heat fusible material comprises a metal alloy.

5. A thermal interface according to claim 4, wherein said alloy comprises an alloy of bismuth, tin and indium.

6. A thermal interface according to any preceding claim, wherein said thermal transfer surface is treated to increase a wettability of said surface to said liquid heat fusible material.

7. A thermal interface according to claim 6, wherein said thermal transfer surface is treated by coating said surface with a substance that increases a wettability of said heat transfer surface to said liquid heat fusible material.

8. A thermal interface according to any preceding claim, further comprising a retainer projection projecting from said thermal transfer surface and operable to retain said heat fusible material adjacent to said thermal transfer surface when said heat source is connected to said heat sink and said heat fusible material has melted.

9. A detachable connector for connecting a heat source to a heat sink, said detachable connector comprising said thermal interface according to any preceding claim.

10. A detachable connector according to claim 9, wherein said detachable connector is configured such that when in a connected state a thermal transfer path is provided between said thermal transfer surface and a surface abutting said thermal transfer surface, a thermal conductivity of said thermal path increasing when said heat fusible material melts, said heat fusible material at least partially filling a gap between said thermal transfer surface and said abutting surface when melted.

11. A detachable connector according to claim 9 or 10, comprising a spring loaded connecting member for biasing said thermal transfer surface towards a corresponding surface when said detachable connector is connected.

12. A detachable connector according to any preceding claim, said detachable connector comprising a recess for enclosing a protruding portion of a device to which it is connected, said recess being at least partially coated with said heat fusible material and comprising a retaining ring at an outer edge of said recess for retaining said heat fusible material when liquid.

13. A heat sink comprising a thermal interface according to any one of claims 1 to 8 and a heat sink body said heat sink body being in thermal contact with said thermal transfer surface.

14. A heat transfer assembly comprising a heat sink and a heat source, said heat sink being connected to said heat source by said detachable connector according to any one of claims 9 to 12, wherein said heat sink and said heat source are connected such that said thermal transfer surface abuts a corresponding surface of one of said heat source and said heat sink, said thermal transfer and corresponding surfaces being arranged such that said heat fusible material when melted at least partially fills a gap between said thermal transfer surface and said corresponding surface providing an improved thermally conductive path between said heat sink and said heat source.

15. A method of adapting a connector for thermally connecting a heat source and a heat sink comprising providing a heat fusible material having a melting temperature of between 15 and 110°C on at least a portion of a thermal transfer surface of said connector such that when solid said heat fusible material rigidly adheres to said at least a portion of said thermal transfer surface.
